(19) Europäisches Patentamt
European Patent Office
Office européen des brevets

(11) EP 0 854 580 A2

(12) EUROPÄISCHE PATENTANMELDUNG

(43) Veröffentlichungstag:
22.07.1998 Patentblatt 1998/30

(51) Int. Cl.⁶: H03M 1/80

(21) Anmeldenummer: 97122580.0

(22) Anmeldetag: 19.12.1997

(84) Benannte Vertragsstaaten:
AT BE CH DE DK ES FI FR GB GR IE IT LI LU MC NL PT SE
Benannte Erstreckungsstaaten:
AL LT LV MK RO SI

(30) Priorität: 14.01.1997 DE 19700983

(72) Erfinder:
• Schmitt-Landsiedel, Doris, Prof.-Dr.
85521 Ottobrunn (DE)
• Thewes, Roland, Dr.
82194 Gröbenzell (DE)
• Luck, Andreas
81737 München (DE)
• Weber, Werner, Dr.
80637 München (DE)

(71) Anmelder:
SIEMENS AKTIENGESELLSCHAFT
80333 München (DE)

(54) **Digital/Analog-Umsetzer**

(57) Der Anmeldungsgegenstand betrifft einen Digital/Analog-Umsetzer, der einen Neuron-MOS-Transistor, eine Einrichtung zur Konstanthaltung eines Drain-Potentials des Neuron-MOS-Transistors und eine Stromquelle aufweist. Durch die spezielle Beschaltung ist ein großsignalmäßig linearer Aussteuerbereich möglich, wodurch auch Umsetzer mit einer größeren Eingangswortbreite als beispielsweise nur zwei Bit in einfacher Weise mit geringer Verlustleistung realisierbar sind. Derartige Umsetzer sind vor allem für ULSI-Schaltungen von Bedeutung.

FIG 1

EP 0 854 580 A2

**Beschreibung**

Aufgrund der positiven Eigenschaften, wie beispielsweise geringer Platzverbrauch, geringe Verlustleistung und einfacher Aufbau, bilden Neuron-MOS-Transistoren eine ideale Ausgangsbasis für eine große Zahl interessanter Schaltungsanwendungen, insbesondere im Bereich der ULSI-Schaltungen.

Aus der IEEE Transactions on Electron Devices, VOL. 39, No. 6, June 1992, Seiten 1444 bis 1455 ist insbesondere aus Figur 16 auf der Seite 1453 ein Zwei-Bit-Digital/Analog-Umsetzer auf der Basis von Neuron-MOS-Transistoren bekannt. Hierbei handelt es sich um einen sehr einfachen Digital/Analog-Umsetzer mit zwei komplementären Neuron-MOS-Transistoren auf dessen gemeinsames Floating Gate ein Eingang mit der Gewichtung 1 und ein Eingang mit der Gewichtung 2 wirkt. Auf diese Weise sind jedoch keine Digital/Analog-Umsetzer mit einer größeren Eingangswortbreite als zwei Bit wegen der Nichtlinearität der Schaltung zu erzielen.

Die der Erfindung zugrundeliegende Aufgabe besteht nun darin, einen Digital/Analog-Umsetzer auf der Basis von Neuron-MOS-Transistoren anzugeben, der auch für eine größere Eingangswortbreite als zwei Bit geeignet ist und einen möglichst geringen schaltungstechnischen Mehraufwand erfordert.

Diese Aufgabe wird erfindungsgemäß durch die im Patentanspruch 1 angegebenen Merkmale gelöst. Vorteilhafte Ausgestaltungen der Erfindung ergeben sich aus den Unteransprüchen.

Die Erfindung wird nachfolgend anhand der Zeichnungen näher erläutert. Dabei zeigt

Figur 1    einen erfindungsgemäßen Digital/Analog-Umsetzer,

Figur 2    einen erfindungsgemäßen Digital/Analog-Umsetzer mit einstellbarem Aussteuerbereich,

Figur 3    eine schematische Schnittdarstellung zur Erläuterung einer vorteilhaften Ausgestaltung des Neuron-MOS-Transistors des erfindungsgemäßen Digital/Analog-Umsetzers,

Figur 4    eine schematische Schnittdarstellung einer weiteren vorteilhaften Ausgestaltung des Neuron-MOS-Transistors des erfindungsgemäßen Digital/Analog-Umsetzers und

Figur 5    einen erfindungsgemäßen hochauflösenden Digital/Analog-Umsetzer auf der Basis von zwei erfindungsgemäßen Digital/Analog-Umsetzern entsprechend der Figuren 1 bis 4.

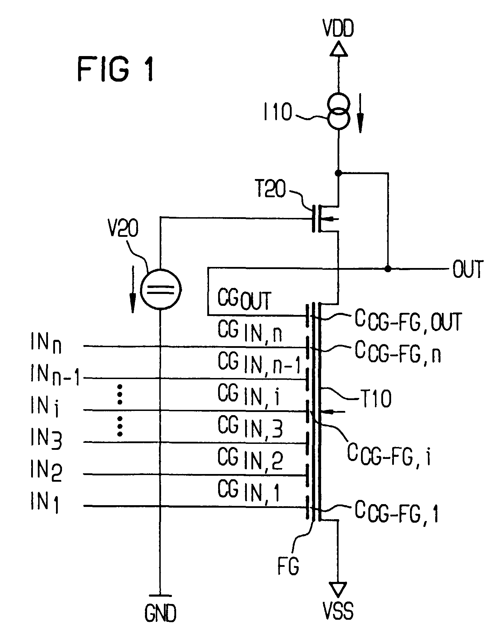

In Figur 1 ist ein erfindungsgemäßer Digital/Analog-Umsetzer mit einem Neuron-MOS-Transistor T10, einer aus einem MOS-Transistor T20 und einer Spannungsquelle V20 bestehenden Einrichtung zur Konstanthaltung des Drain-Potentials des Neuron-MOS-Transistors und einer Konstantstromquelle I10 dargestellt, wobei ein erster Anschluß der Konstantstromquelle mit einer Versorgungsspannung VDD und ein zweiter Anschluß der Konstantstromquelle mit einem ersten Anschluß des Transistors T20 verbunden ist, dessen zweiter Anschluß über die Drain-Source-Strecke des Neuron-MOS-Transistors T10 mit der weiteren Versorgungsspannung VSS verbunden ist. Häufig werden die Spannungen VDD und VSS symmetrisch zum Massepotential GND des Digital/Analog-Umsetzers ausgeführt. Das Gate des Transistors T20 ist über die Spannungsquelle V20 mit dem Massepotential GND und der mit der Stromquelle verbundene Anschluß des Transistors T20 mit einem Analogausgang OUT sowie mit einer Elektrode $CG_{OUT}$ (Koppelgate) des Neuron-MOS-Transistors verbunden. Es wird angenommen, daß der Ausgang OUT im ohmschen Sinne unbelastet ist, daß er also beispielsweise mit einer Gateelektrode eines weiteren nachgeschalteten MOS-Transistors verbunden ist, und somit der eingeprägte Konstantstrom I10 ausschließlich über den Transistor T20 durch den Neuron-MOS-Transistor T10 fließt.

Die Konstanthaltung des Drainpotentials des Transistors T10 wird wie folgt bewirkt:
Da der Transistor T20 im nominalen Betriebsfall in Sättigung arbeitet, stellt sich eine konstante Gate-Source-Spannung am Transistor T20 ein. Da wiederum das Gatepotential des Transistors T20 über die Spannungsquelle V20 vorgegeben ist, ergibt sich auch ein konstantes Source-Potential des Transistors T20 und somit auch ein konstantes Drain-Potential des Neuron-MOS-Transistors T10. Bei einer entsprechenden Wahl der Spannung der Konstantspannungsquelle V20 ergibt sich ein weiter Aussteuerungsbereich mit linearem Übertragungsverhalten.

Der Digital/Analog-Umsetzer weist parallele digitale Umsetzereingänge $IN_1...IN_n$ auf, die mit entsprechenden Elektroden $CG_{IN,1} ... CG_{IN,n}$ des Neuron-MOS-Transistors T10 verbunden sind, wobei diese Elektroden zusammen mit einem Floating Gate FG des Neuron-MOS-Transistors T10 Koppelkapazitäten $C_{CG-FG,1} ... C_{CG-FG,n}$ bilden. Ein Umsetzereingang $IN_i$ mit dem Stellenwert i im Eingangswort ist über eine Koppelkapazität $C_{CG-FG,i}$ verbunden, die um den Faktor $2^{i-1}$ größer ist als eine zum Umsetzereingang $IN_1$ mit dem Stellenwert i=1 gehörige kleinste Koppelkapazität $C_{CG-FG,1}$. Die aus der Elektrode $CG_{OUT}$ und dem Floating Gate FG gebildete Kapazität $C_{CG-FG,OUT}$ kann beispielsweise so groß sein wie die Summe aller mit den Eingängen verbundenen Koppelkapazitäten.

Die Koppelkapazitäten werden vorteilhafterweise durch die Elektrodenflächen eingestellt, da die Koppelkapazitäten proportional zu den Elektrodenflächen sind und die Elektrodenflächen im Vergleich zu einer Variation der relativen Dielektrizitätskonstante oder des Plattenabstandes am einfachsten und reproduzierbarsten einzustellen sind.

Der Ausgang OUT der Schaltung liefert folgende Ausgangsspannung:

$$V_{OUT} = \frac{C_{ges}}{C_{CG\text{-}FG,OUT}} \, x V_0 - \sum_{i=1}^{n} \frac{C_{CG\text{-}FG,i}}{C_{CG\text{-}FG,OUT}} \, x V_{IN,i} \, ,$$

wobei $C_{ges}$ die Summe aller Kapazitäten, deren eine Elektrode das Floating Gate ist, darstellt, die sich wie folgt berechnet:

$$C_{ges} = C_{CH\text{-}FG} + C_{CG\text{-}FG,OUT} + \sum_{i=1}^{n} C_{CG\text{-}FG,i} \, .$$

Die Kapazität $C_{CH\text{-}FG}$ wird dabei durch den Kanal und das Floating Gate des Neurontransistors T10 gebildet. Die Spannung $V_0$ ist eine Funktion des eingestellten Arbeitspunktes des Transistors T10. Ferner spielt auch eine eventuelle prozeßbedingte Aufladung des Floating Gates eine Rolle. Beispielsweise durch geeignete Wahl eines Konstantstromes I10 und/oder durch ein zusätzliches Koppelgate, das mit einer Abgleichspannung verbunden ist, kann die Spannung $V_0$ auf 0 Volt abgeglichen werden. Unter dieser Annahme ergibt sich für die Ausgangsspannung folgende Übertragungsfunktion des erfindungsgemäßen Digital/Analog-Umsetzers:

$$V_{OUT} = - \sum_{i=1}^{n} \frac{C_{CG\text{-}FG,i}}{C_{CG\text{-}FG,OUT}} \, x \, V_{IN,i}$$

Wird eine symmetrische Versorgungsspannung, das heißt VDD = - VSS unterstellt und das digitale Eingangswort mit den Eingangsbits $b_i$ mit i = 1 ... n so definiert, daß die Spannung $V_{IN,i}$ = VDD ist, sofern das Eingangsbit $b_i$ gleich Logisch Eins ist und die Eingangsspannung $V_{IN,i}$ = VSS ist, sofern das Eingangsbit $b_i$ gleich Logisch Null ist, kann die Ausgangsspannung $V_{OUT}$ in Abhängigkeit der Eingangsbits $b_i$ wie folgt berechnet werden:

$$V_{OUT} = - \sum_{i=1}^{n} \frac{C_{CG\text{-}FG,i}}{C_{CG\text{-}FG,OUT}} \, x \left( 2 \, x \left( b_i - \frac{1}{2} \right) \right) x VDD$$
$$= - \frac{C_{CG\text{-}FG,1}}{C_{CG\text{-}FG,OUT}} x VDD x \sum_{i=1}^{n} 2^i x \left( b_i - \frac{1}{2} \right)$$

Der lineare Aussteuerbereich hängt vom konkreten Design der Schaltung und von den Eigenschaften der tatsächlichen Schaltung der Stromquelle I10 ab und bewegt sich zwischen ca. 60 Prozent und 96 Prozent der beiden Versorgungsspannungen VDD und VSS.

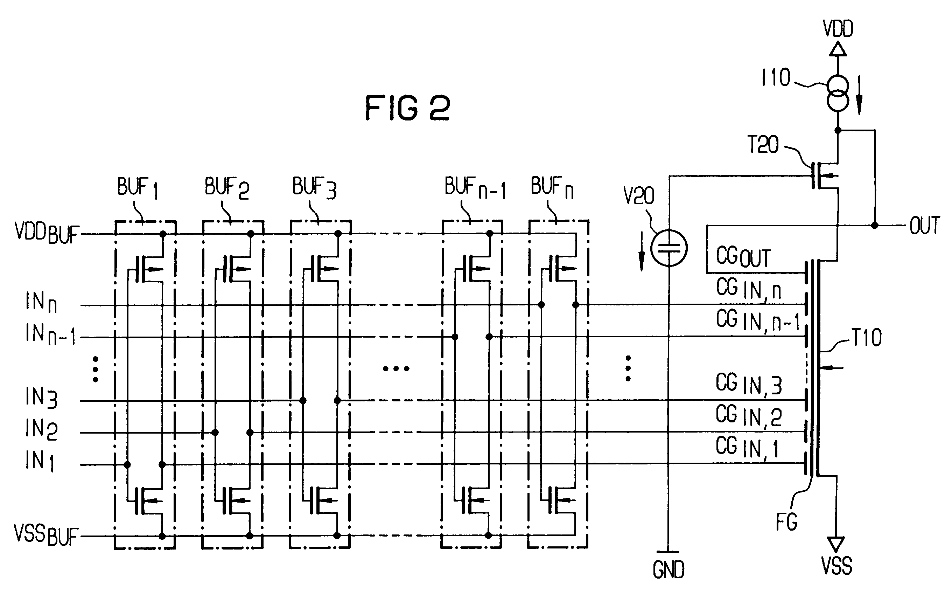

In vielen Anwendungen kann es von Nutzen sein, den Aussteuerbereich für Analogsignale variabel zu gestalten, wobei dessen Grenzen durch extern an die Schaltung des Umsetzers anzulegende Spannungen eingestellt werden. Figur 2 zeigt eine entsprechende Ausgestaltung des Digital/Analog-Umsetzers, wobei hier die Koppelgates $CG_{IN,i}$ nicht direkt mit den Eingängen $IN_1$ ... $IN_n$, sondern über Inverter $BUF_1$ ... $BUF_n$ zur Pufferung der Eingangssignale $V_{IN,i}$ verbunden sind. Dabei werden die Source-Knoten der n-MOS-Transistoren dieser Inverter an eine Spannung $VSS_{BUF}$ und die Source-Knoten der p-MOS-Transistoren an eine Spannung $VDD_{BUF}$ angeschlossen. Die Spannungen $VSS_{BUF}$ und $VDD_{BUF}$ müssen so gewählt sein, daß sie innerhalb des linearen Bereiches der Übertragungsfunktion des Umsetzers nach Figur 1 liegen. Wenn für das Ausgangskoppelgate die Dimensionierung von

$$C_{CG\text{-}FG,OUT} = \sum_{i=1}^{n} C_{CG\text{-}FG,i} = (2^n - 1) x C_{CG\text{-}FG,1}$$

gewählt wird, kann sich am Ausgang OUT nun eine minimale Spannung von $-VDD_{BUF}$ und eine maximale Spannung von $|VSS_{BUF}|$ einstellen. Die Übertragungsfunktion lautet in diesem Fall:

$$V_{OUT} = -\left(VDD_{BUF} + VSS_{BUF} \times \frac{1}{2^n - 1} \sum_{i=1}^{n} 2^{i-1} \times b_i\right)$$

$$= -VDD_{BUF} + |VSS_{BUF}| \times \frac{1}{2^n - 1} \sum_{i=1}^{n} 2^{i-1} \times b_i$$

Die Kapazitätsverhältnisse der Eingangskoppelgates der in Figur 1 und 2 gezeigten Digital/Analog-Umsetzer genügen einer Potenzfunktion zur Basis 2. Um zu gewährleisten, daß die vorgesehene Gewichtung in deren schaltungs- bzw. layouttechnischer Umsetzung möglichst gut eingehalten wird, ist es sinnvoll, den Neuron-MOS-Transistor T10 mit einer hinreichend großen Anzahl von Teilelektroden bzw. Einheitskoppelgates zu verwenden. Dabei ist jeweils eine entsprechend Anzahl dieser Teilelektroden parallel zu schalten, um die Signale, welche zur Ansteuerung des Neuron-Transistors T10 verwendet werden, mit der gewünschten Gewichtung zu versehen. Ferner bietet es sich an, ein Einheitskoppelgate $CG_{IN,1}$, an welches das Signal $IN_1$ mit der geringsten Gewichtung geführt wird, mittig zwischen allen weiteren Einheitskoppelgates anzuordnen und die Einheitskoppelgates, an welche Signale mit höherer Gewichtung gelegt werden, beidseits symmetrisch zu diesem ersten Koppelgate zu positionieren.

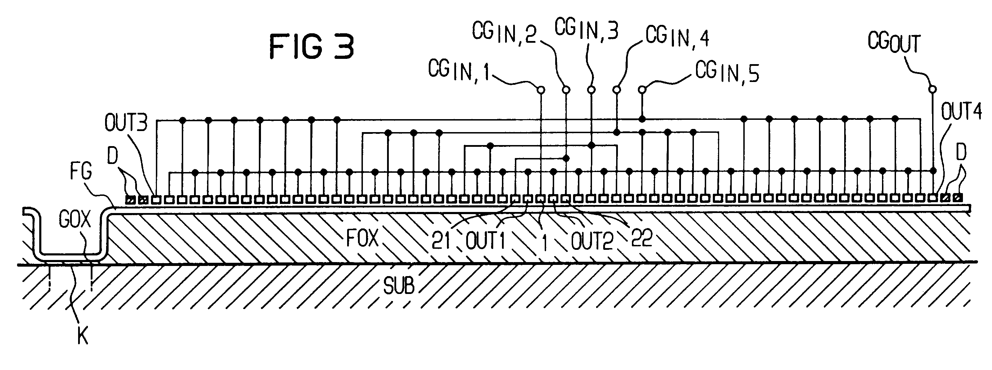

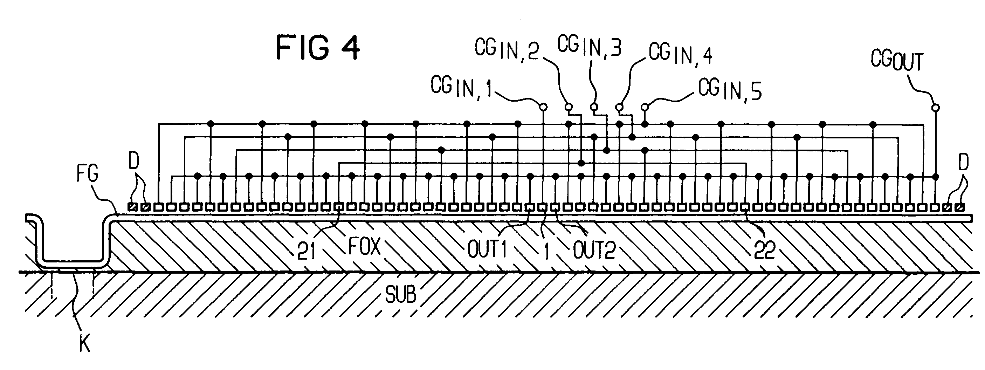

In den Figuren 3 und 4 sind zwei beispielhafte Ausgestaltungen eines solchen Neuron-Transistors T10 für beispielsweise fünf Eingangsbits dargestellt. In beiden Fällen ist ein Floatig Gate FG gezeigt, das in einem Kanalbereich K durch ein Gateoxid GOX und im übrigen Bereich durch ein Feldoxid FOX von einem Substrat SUB getrennt ist. In beiden Fällen besteht das Koppelgate aus $CG_{IN,1}$ mit der geringsten Wertigkeit lediglich aus einer Teilelektrode 1 und neben dieser mittig angeordneten Teilekektrode 1 sind alle weiteren Teilelektroden, die die höherwertigen Koppelgates repräsentieren dazu symmetrisch angeordnet.

In Figur 3 liegen beispielsweise die Teilelektroden OUT1 und OUT2, die einen Teil des Koppelgates $CG_{OUT}$ darstellen, symmetrisch unmittelbar neben der Teilelektrode 1 und werden gefolgt von den beiden Teilelektroden 21 und 22 die zusammen das Koppelgate $CG_{in,2}$ bilden.

Der Neuron-MOS-Transistor von Figur 4 unterscheidet sich von dem in Figur 3 gezeigten lediglich in der Abfolge der Teilelektroden, wobei beispielsweise die beiden Teilelektroden 21 und 22 jeweils ungefähr in der Mitte der beiden symmetrisch zur Elektrode 1 liegenden Elektrodenbereiche plaziert sind.

Sowohl in Figur 3 und 4 sind in einem Randbereich außerhalb der zu der Elektrode 1 symmetrischen Elektrodenbereichen sogenannte Dummy-Teilelektroden vorgesehen. Diese sollen bewirken, daß alle signalführenden Koppelgates des Neuron-MOS-Transistors T10 hinsichtlich der Topologie ihrer unmittelbaren Nachbarschaft ähnliche Verhältnisse vorfinden, was wiederum die Übereinstimmung der durch die Flächenverhältnisse eingestellten Kapazitätswerte und den tatsächlichen Kapazitätswerten verbessert.

Wie aus der bisherigen Beschreibung hervorgeht, steigt die Anzahl der Koppelgates exponentiell mit der Wortbreite des Eingangssignals, das heißt mit der Anzahl der zu verarbeitenden Bits und somit mit der geforderten Auflösung. Im Falle eines 8 Bit Umsetzers wurde der Neuron-Transistor $2^{8-1}$ Teilelektroden für die Eingangssignale und weitere $2^{8-1}$ Teilelektroden für das Ausgangssignal sowie gegebenenfalls einige Dummy-Teilelektroden benötigen, das heißt in der Summe etwa $2^9 = 512$ Einheitskoppelgates.

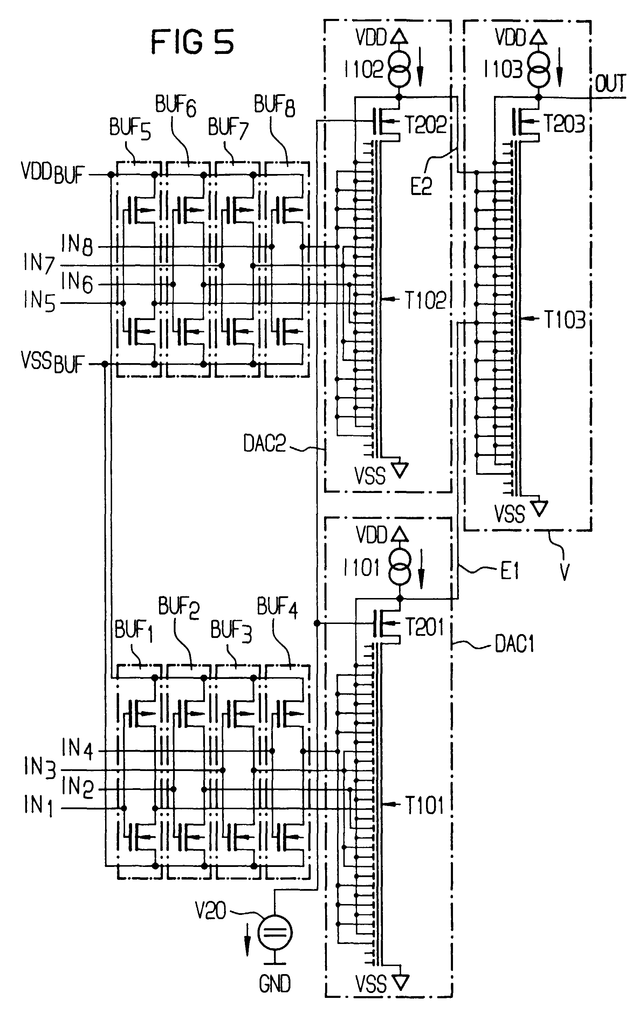

In Figur 5 ist ein Ausführungsbeispiel für einen erfindungsgemäßen Umsetzer gezeigt, mit dem sich der dieser Aufwand reduzieren läßt bzw. mit dem der Einsatz derartig großer Neuron-MOS-Transistoren vermieden wird. Der 8 Bit Kaskadenumsetzer besteht hierbei im Grunde aus zwei Umsetzern wie sie in Figur 1 bzw. in Figur 2 gezeigt sind. Im hier gezeigten Beispiel sind die niederwertigen vier Eingängen $IN_1 \ldots IN_4$ über Inverter $BUF_1 \ldots BUF_4$ mit einem Umsetzer DAC1 gemäß Figur 1 und die höherwertigen vier Eingänge $IN_5 \ldots IN_8$ über Inverter $BUF_5 \ldots BUF_8$ mit einem weiteren Umsetzer DAC2 gemäß Figur 1 verbunden. Ein Ausgang E1 des Umsetzers DAC1 wird in einem Summierverstärker V mit einem Gewicht $2^{-4}$ und ein Ausgang E2 des Umsetzers DAC2 mit einem Gewicht 1 aufsummiert. Im allgemeinen Fall, wenn k die maximale Wertigkeit des Umsetzers DAC1 darstellt, wird der Ausgang E1 mit dem Faktor $2^{-k}$ gewichtet. Der Verstärker V kann dabei vorteilhafterweise ähnlich wie die beiden Umsetzer DAC1 und DAC2 aufgebaut werden.

Selbstverständlich ist es möglich, alle gezeigten Schaltungen auch komplementär zu den gezeigten Ausführungsbeispielen aufzubauen. In diesem Falle müssen die Anschlüsse VDD und VSS vertauscht werden sowie alle n-Kanal-Transistoren mit p-Kanal-Transistoren und umgekehrt vertauscht werden.

**Patentansprüche**

1. Digital/Analog-Umsetzer,
bei dem ein Neuron-MOS-Transitor (T10), eine Einrichtung (T20,V20) zur Konstanthaltung des Drainpotentials des Neuron-MOS-Transitors und eine Stromquelle (I10) in Reihe geschaltet sind, wobei die Stromquelle mit einer ersten Versorgungsspannung (VDD) und der Neuron-MOS-Transistor mit einer zweiten Versorgungsspannung (VSS) verbunden sind,

bei dem Umsetzereingänge ($IN_1...IN_n$) für ein digitales Eingangswort über Koppelkapazitäten ($C_{CG\text{-}FG,1}....C_{CG\text{-}FG,n}$) kapazitiv mit einem Floating-Gate (FG) des Neuron-MOS-Transitors derart verbunden sind, daß ein jeweiliger Umsetzereingang mit einem Stellenwert i mit dem Floating-Gate (FG) über eine Koppelkapazität ($C_{CG\text{-}FG,i}$) verbunden ist, die um den Faktor $2^{i-1}$ größer ist als eine zum Umsetzereingang ($IN_1$) mit dem Stellenwert i=1 gehörige kleinste Koppelkapazität ($C_{CG\text{-}FG,1}$), und bei dem ein Umsetzerausgang (OUT) direkt mit der Stromquelle (I10) und kapazitiv über eine weitere Koppelkapazität ($C_{CG\text{-}FG,OUT}$) mit dem Floating-Gate (FG) verbunden ist.

**2.** Digital/Analog-Umsetzer nach Anspruch 1,
bei dem die Einrichtung zur Konstanthaltung des Drainpotentials des Neuron-MOS-Transitors einen MOS-Transistor (T20) enthält, dessen erster Anschluß mit der Stromquelle, dessen zweiter Anschluß mit dem Drainanschluß des Neuron-MOS-Transistors (T10) und dessen Gate-Anschluß über eine Spannungsquelle (V20) mit Bezugspotential (GND) verbunden sind.

**3.** Digital/Analog-Umsetzer nach Anspruch 1 oder 2,
bei dem zwischen den Umsetzereingängen und den Koppelkapazitäten Eingangsinverterstufen ($BUF_1...BUF_n$) vorgesehen sind, deren Versorgungsspannungen ($VDD_{BUF}$, $VSS_{BUF}$) dem Betrag nach kleiner als die erste und zweite Versorgungsspannung (VDD,VSS) sind.

**4.** Digital/Analog-Umsetzer nach einem der vorhergehenden Ansprüche, bei denen mit den Umsetzereingängen direkt oder indirekt verbundene Elektroden ($CG_{IN,1}..GG_{IN,n}$) der Koppelkapazitäten und/oder eine Elektrode ($CG_{OUT}$) der weiteren Koppelkapazität ($C_{CG\text{-}FG,OUT}$), die mit dem Umsetzerausgang (OUT) verbunden ist, in eine Mehrzahl von Teilelektroden aufgeteilt sind, wobei jeweils benachbarte Teilelektroden (1,21; 1,OUT1) entweder mit zueinander unterschiedlichen Eingängen ($IN_1,IN_2$) oder mit einem Eingang ($IN_1$) und einem Ausgang (OUT) verbunden sind.

**5.** Digital/Analog-Umsetzer nach Anspruch 4,
bei dem die mit dem Umsetzereingang ($IN_i$) des Stellenwertes i verbundene Elektrode ($GG_{IN,2}$) aus i gleichgroßen Teilelektroden (21, 22) besteht.

**6.** Digital/Analog-Umsetzer nach Anspruch 4 oder 5,
bei dem Teilelektroden (OUT3,OUT4) im Randbereich benachbarte Teilelektroden (D) aufweisen, die weder mit einem Umsetzereingang noch mit dem Umsetzerausgang verbunden sind.

**7.** Digital/Analog-Umsetzer (DAC1) nach einem der vorhergehenden Ansprüche, der k Umsetzereingänge ($IN_1..IN_4$) mit niedrigem Stellenwert aufweist und der ausgangsseitig mit einem $2^{-k}$-fach gewichteten Eingang (E1) eines Summationsverstärkers (V) verbunden ist, dessen mit Eins gewichteter Eingang (E2) mit einem Ausgang eines weiteren Digital/Analog-Umsetzers (DAC2) verbunden ist, der weitere Umsetzereingänge ($IN_5..IN_8$) mit hohem Stellenwert aufweist.

# FIG 1

# FIG 2

EP 0 854 580 A2

FIG 3

EP 0 854 580 A2

# FIG 4

FIG 5